Europäisches Patentamt

European Patent Office

Office européen des brevets

(11) Veröffentlichungsnummer: **0 218 842**
**A2**

## (12) EUROPÄISCHE PATENTANMELDUNG

(21) Anmeldenummer: 86111151.6

(22) Anmeldetag: 12.08.86

(51) Int. Cl.⁴: **C30B 23/00** , C30B 29/10 , C30B 29/60

(30) Priorität: 07.09.85 DE 3531949

(43) Veröffentlichungstag der Anmeldung:
22.04.87 Patentblatt 87/17

(84) Benannte Vertragsstaaten:
CH DE FR GB IT LI NL SE

(71) Anmelder: HOECHST AKTIENGESELLSCHAFT
Postfach 80 03 20
D-6230 Frankfurt am Main 80(DE)

(72) Erfinder: Betz, Thomas, Dr.
Am Hofacker 20
D-5276 Wiehl-Bielstein(DE)
Erfinder: von Schnering, Hans-Georg, Dr.
Theodor-Strom-Weg 7
D-7031 Aidlingen(DE)
Erfinder: Schönherr, Erich, Dr.
Schulstrasse 3
D-7250 Leonberg(DE)

(54) Verfahren zur Herstellung von beta-Zinkdiphosphid-Einkristallen.

(57) Beim Verfahren zur Herstellung von $\beta$-Zinkdiphosphid-Einkristallen ($\beta$-ZnP$_2$) mit einem Durchmesser von mindestens 7 mm füllt man eine Quarzampulle zu 70 bis 90 Vol% mit polykristallinem $\beta$-ZnP$_2$, schmilzt sie zu, zieht sie senkrecht mit einer Ziehgeschwindigkeit von 0,5 bis 2,5 mm pro Tag im Verlauf von 24 bis 120 Tagen durch einen Ofen, dessen vertikales Temperaturprofil durch eine untere Eintrittstemperatur von 580 bis 780°C, eine mittlere Maximaltemperatur von 800 bis 950°C und eine obere Austrittstemperatur von 350 bis 400°C bestimmt ist, und entnimmt das über die Gasphase durch Sublimation in den oberen Ampullenbereich zu einem Einkristall kondensierte $\beta$-ZnP$_2$ nach Zerschlagen der Ampulle.

EP 0 218 842 A2

## Verfahren zur Herstellung von β-Zinkdiphosphid-Einkristallen

Die Erfindung betrifft ein Verfahren zur Herstellung von β-Zinkdiphosphid-Einkristallen (β-ZnP₂) mit einem Durchmesser von mindestens 7 mm.

Dieses Material ist aufgrund seiner photovoltaischen Eigenschaften von besonderer Bedeutung. Da während der letzten Jahrzehnte die Verwendung von Halbleitern stark zugenommen hat, ergibt sich eine gesteigerte Nachfrage nach Halbleiterwerkstoffen mit immer breiter werdenden Anwendungsmöglichkeiten. Insbesondere nimmt die potentielle Bedeutung eines Halbleiters stark zu, wenn ein solcher Werkstoff zusätzlich nutzbare photoelektrische Kenndaten aufweise, z.B. zu einer wirtschaftlichen Konversion von Sonnenlicht in elektrische Potentiale in der Lage ist, was bei einkristallinem Material gegeben ist.

Stand der Technik ist die Synthese von β-ZnP₂ durch Festkörperreaktion von Zink oder Zn₃P₂ mit rotem Phosphor in geschlossenen Reaktionssystemen, wobei man β-ZnP₂ in Form nadeliger, z.T. hohlförmiger Kristalle erhält, die zur Zwillingsbildung mit pseudoorthorhombischer Symmetrie neigen. Die Größe dieser Kristallindividuen beträgt nur wenige Millimeter, wodurch ihre technische Anwendung stark eingeschränkt ist. Darüber hinaus ist die ziemlich große Korrosionsanfälligkeit in feuchter Luft oder in wäßrigen Elektrolytsystemen von Nachteil.

Allerdings wird auch von größeren β-ZnP₂-Einkristallen (Länge 50 mm, Durchmesser 12 mm) berichtet, die bei Anwendung von Phosphordrücken von 20 000 bis 50 000 bar aus einer Zn-P-Schmelze entstehen sollen (W. Zdanowicz et al., Ac. Phys. Pol. A 48, 27-31 (1975)). Vom verfahrenstechnischen Standpunkt ist die Beherrschung derart hoher Phosphordrücke jedoch äußerst problematisch und für eine industrielle Produktion prohibitiv.

β-ZnP₂ schmilzt bei 990°C inkongruent, d.h. unter Zersetzung zu Zn₃P₂ und P und Bildung eines Peritektikums. Man nahm daher an, daß sich ZnP₂ auch bei Sublimationsexperimenten in Zn₃P₂ und gasförmigen Phosphor zersetzen würde.

Das Verfahren der vorliegenden Erfindung zur Herstellung von β-Zinkdiphosphid-Einkristallen mittels der an sich bekannten Pizzarello-Technik zeigt jedoch überraschenderweise, daß man β-ZnP₂ über die Gasphase bei geeigneter Wahl der Reaktionsparameter in einkristalliner Form ohne Zersetzung gewinnen kann. (Zur Pizzarello-Technik vgl. F. Pizzarello, J. Appl. Phys. 25 (1954), 804 und E. Schönherr, The Growth of Large Crystals from the Vapor Phase, in: Crystals -Growth, Properties and Applications, Bd. 2, herausgegeben von H.C. Freyhardt, S. 51-118, Springer-Verlag, Berlin 198o)

Als Ausgangsstoff setzt man polykristallines - (nadelförmig kristallisiertes) β-ZnP₂ ein, das in an sich bekannter Weise durch Festkörperreaktion, z.B. durch Tempern inniger Gemenge von Zink und rotem Phosphor gemäß Zn + 2P (rot) = ZnP₂ über die Gasphase gewonnen wurde (vgl. z.B. T.A. Mowles, C.A. 91 (1979), 66453 k ). Die kinetische Hemmung der Sublimation wurde durch Zusatz katalytischer Mengen leichtflüchtiger Substanzen, wie I₂ oder P₂I₄, aufgehoben. Die in der Mitte der Reaktionsampulle abgeschiedenen monoklinen, z.T. hohlförmigen Kristalle von β-ZnP₂ wurden röntgenographisch nach dem Guinier-Jagodzinski-Verfahren in der Guinier-Kammer untersucht, wobei die Röntgenaufnahmen das Vorliegen phasenreiner Proben von β-ZnP₂ anzeigen.

Das Verfahren der Erfindung ist im einzelnen dadurch gekennzeichnet, daß man eine Quarzampulle zu 70 bis 90 Vol% mit polykristallinem β-ZnP₂ füllt, zuschmilzt, senkrecht mit einer Ziehgeschwindigkeit von 0,5 bis 2,5 mm pro Tag im Verlauf von 24 bis 120 Tagen durch einen Ofen zieht, dessen vertikales Temperaturprofil durch eine untere Eintrittstemperatur von 580 bis 780°C, eine mittlere Maximaltemperatur von 800 bis 950°C und eine obere Austrittstemperatur von 350 bis 400°C bestimmt ist, und das über die Gasphase durch Sublimation in den oberen Ampullenbereich zu einem Einkristall kondensierte β-ZnP₂ nach Zerschlagen der Ampulle entnimmt.

Das Verfahren der Erfindung kann darüber hinaus wahlweise und bevorzugt dadurch gekennzeichnet sein, daß

a) man die Quarzampulle während der Beheizung unter einen äußeren Inertgasdruck von 20 bis 60 bar setzt;

b) die Quarzampulle am oberen Ende eine Einschnürung aufweist;

c) man den entnommenen β-ZnP₂-Einkristall in Scheiben sägt.

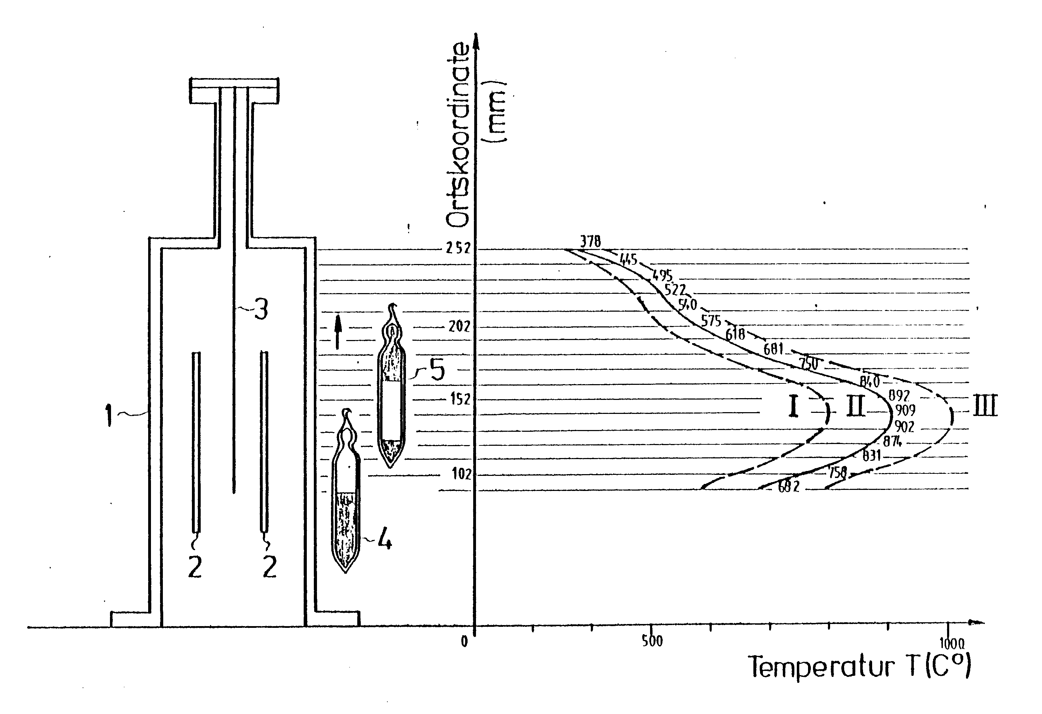

Das Verfahren der Erfindung läßt sich in einem zylindrischen Züchtungsreaktor (1) durchführen, der auf der linken Seite der Abbildung schematisch im Schnitt und in vereinfachter Form dargestellt ist. Er enthält einen rohrförmigen Graphitwiderstandsheizer (2), der mit Hilfe eines durch ein Thermoelement gesteuerten Temperaturreglers derart beheizt wird, daß ein Temperaturprofil als Funktion der Höhe zustandekommt, wie es auf der rechten Seite der Abbildung beispielhaft und nicht maßstäblich wiedergegeben ist. Die Reglertemperaturen liegen für Kurve I bei 650°C, für Kurve II bei 760°C und für Kurve III bei 875°C. Mittels eines Ziehgestänges (3) wird eine mit β-ZnP₂ gefüllte Quarzampulle äußerst langsam (z.B. 2 mm/d) im Verlauf von Wochen nach oben durch den Graphitwiderstandsheizer (2) gezogen. Rechts neben dem Züchtungsreaktor (1) ist symbolisch und nicht maßstäblich eine gefüllte Ampulle, die am oberen Ende eine Einschnürung aufweist, höhenverschoben vor und nach der Einkristallzüchtung dargestellt (4 bzw. 5). Die Einschnürung am oberen Ampullenende dient der Selektion eines Kristallkeims.

Der Züchtungsreaktor (1) kann evakuiert und anschließend unter einen Inertgasdruck (Argon oder Stickstoff) von z.B. 50 bar gesetzt werden, wodurch es möglich ist, den sich während des Kristallzüchtungsprozesses in der Quarzampulle aufbauenden Druck extern zu kompensieren.

Das hier verwendete Temperaturprofil bietet den besonderen Vorteil, daß der für das Einkristallwachstum notwendige übersättigte Bereich der Gasphase dank einem steilen Temperaturgradienten auf einen schmalen lokalen Bereich der Ampulle unmittelbar vor der Phasengrenze zum wachsenden Einkristall hin beschränkt ist. Auf diese Weise wird die Tendenz zur Ausbildung von "Parasitkeimen" minimiert.

Das erfindungsgemäß einkristallin hergestellte $\beta$-ZnP$_2$ eignet sich aufgrund seiner physikalischen Kenndaten (direkte Band-Lücke (band-gap): $\Delta E \approx 1,4$ eV; el. Leitfähigkeit $\Sigma \approx 5 \cdot 10^{-3} \Omega^{-1} \cdot cm^{-1}$) ausgezeichnet zur Herstellung von Festkörpersolarzellen und Redoxelektrolytsolarzellen, d.h. Ausbildung der Mott-Schottky-Barriere durch Kontakt von Halbleiter/Elektrolyt. Eine n-Dotierung des p-leitenden Materials ist durch Zugabe von Elementen der 6. Hauptgruppe des Periodensystems, besonders von Selen, möglich. Da $\beta$-ZnP$_2$ eine direkte Band-Lücke (band-gap) bei etwa 1,4 eV aufweist, besitzen Solarzellen aus diesem Ma terial einen höheren Wirkungsgrad als solche aus Silicium mit einer indirekten Band-Lücke bei etwa 1,1 eV.

Beispiel

6,3 g eines polykristallinen $\beta$-ZnP$_2$ wurden unter einem Vakuum von $10^{-5}$ mbar in eine Quarzglasampulle eingeschmolzen, die einen Außendurchmesser von 20 mm, eine Wandstärke von 4 mm, eine Länge von 70 mm sowie eine Einschnürung am oberen Ende zur Keimselektion aufwies. Durch Nachtempern der Abschmelzstelle mit einer Wasserstoffflamme wurden Spannungen innerhalb des Glases vermieden. Die so gefüllte und abgeschmolzene Züchtungsampulle wurde im Graphitwiderstandsheizer (2) (Außendurchmesser 50 mm, Innendurchmesser 42 mm, Länge 120 mm) einem Temperaturgradienten entsprechend der Abbildung ausgesetzt. Das sich ergebende Temperaturprofil entspricht einer Einstellung des Temperaturreglers auf 760°C (Abbildung, durchgezogene Kurve II, Eingangstemperatur 682°C, Maximaltemperatur 909°C, Endtemperatur 378°C. Durch Variieren der Reglereinstellungen waren im Ofenraum auch andere Temperaturen zu erzielen - (gestrichelte Kurven I und III der Abbildung).

Im übrigen wurden folgende Reaktionsparameter beachtet:

Ziehstrecke: 60 mm

Ziehgeschwindigkeit 1,7 mm/d

Reaktionsdauer: (60 : 1,7 = 35 Tage)

Füllgrad der Ampulle: 80 %

Arbeitsdruck (Argon): 46 bar

Als Produkt erhielt man nach vollständiger Abkühlung und Zerschlagen der Ampulle 5,6 g eines kompakten, anthrazitgrauen $\beta$-ZnP$_2$-Substanzstücks mit einer durch die Ampul lengeometrie vorgegebenen Morphologie. Mit einer Diamantsäge wurden daraus Scheiben von 2 -5 mm Dicke und 10 -12 mm Durchmesser geschnitten, die anschließend mit Elektro-bzw. Naturkorund definierter Korngröße geschliffen und mit einer Diamantpaste poliert wurden. Das Vorliegen eines Einkristalls wurde röntgenographisch anhand von Schwenkaufnahmen um die drei kristallographischen Achsen der Elementarzelle bestätigt, da polykristalline Domänen nicht erkennbar waren.

Ansprüche

1. Verfahren zur Herstellung von $\beta$-Zinkdiphosphid-Einkristallen ($\beta$-ZnP$_2$) mit einem Durchmesser von mindestens 7 mm, dadurch gekennzeichnet, daß man eine Quarzampulle zu 70 bis 90 Vol% mit polykristallinem $\beta$-ZnP$_2$ füllt, zuschmilzt, senkrecht mit einer Ziehgeschwindigkeit von 0,5 bis 2,5 mm pro Tag im Verlauf von 24 bis 120 Tagen durch einen Ofen zieht, dessen vertikales Temperaturprofil durch eine untere Eintrittstemperatur von 580 bis 780°C, eine mittlere Maximaltemperatur von 800 bis 950°C und eine obere Austrittstemperatur von 350 bis 400°C bestimmt ist, und das über die Gasphase durch Sublimation in den oberen Ampullenbereich zu einem Einkristall kondensierte $\beta$-ZnP$_2$ nach Zerschlagen der Ampulle entnimmt.

2. Verfahren nach Anspruch 1, dadurch gekennzeichnet, daß man die Quarzampulle während der Beheizung unter einen äußeren Inertgasdruck von 20 bis 60 bar setzt.

3. Verfahren nach Anspruch 1 oder 2, <u>dadurch</u> <u>gekennzeichnet</u>, daß die Quarzampulle am oberen Ende eine Einschnürung aufweist.

4. Verfahren nach einem der Ansprüche 1 -3, <u>dadurch</u> <u>gekennzeichnet</u>, daß man den entnommenen $\beta$-ZnP$_2$-Einkristall in Scheiben sägt.